# EUROPÄISCHE PATENTSCHRIFT

(11) **EP 1 162 290 B1**
(45) Veröffentlichungstag und Bekanntmachung des Hinweises auf die Patenterteilung: **28.04.2010**
(21) Anmeldenummer: 01110575.6
(22) Anmeldetag: 30.04.2001
(51) Int. Cl.: C30B 11/00

(54) **Verfahren und Vorrichtung zum Einschmelzen und Erstarren von Metallen und Halbmetallen in einer Kokille**
Process and apparatus for melting and solidifying metals and semi-metals in a crucible
Procédé et appareillage pour la fusion et la solidification des métaux et sémi-métaux dans un creuset

(30) Priorität: 04.05.2000 DE 10021585
(43) Veröffentlichungstag der Anmeldung: 12.12.2001
(73) Patentinhaber: ALD Vacuum Technologies Aktiengesellschaft, 63450 Hanau (DE)
(72) Erfinder: Radel, Günter, 90473 Nürnberg (DE); Schwarz, Dr. Wolfgang, 63589 Linsengericht (DE); Zuckerstätter, Eric, 63571 Gelnhausen (DE)
(74) Vertreter: Hebing, Norbert

(56) Entgegenhaltungen:
- EP-A- 0 289 393
- DE-A- 19 831 388
- GB-A- 2 279 585
- LE GAL M ET AL: "CRYSTAL GROWTH BY THE THERMIC SCREEN TRANSLATION TECHNIQUE;A MODIFIED BRIDGMAN METHOD" JOURNAL OF CRYSTAL GROWTH,NORTH-HOLLAND PUBLISHING CO. AMSTERDAM,NL, Bd. 47, Nr. 3, 1. September 1979 (1979-09-01), Seiten 449-457, XP002009906 ISSN: 0022-0248

## Beschreibung

Die Erfindung betrifft ein Verfahren zum Einschmelzen von Metallen und Halbmetallen in einer Kokille und zum gerichteten Erstarren der Schmelze in dieser Kokille, die einen Boden besitzt, unter dem zur Zufuhr der Schmelzwärme eine Bodenheizeinrichtung und zur Abfuhr der Erstarrungswärme bei der gerichteten Erstarrung eine Kühleinrichtung angeordnet sind, wobei als Bodenheizeinrichtung unter dem Boden der Kokille eine mit Zwischenräumen versehene Widerstandsheizeinrichtung verwendet wird.

Gußblöcke und Formgußteile mit gerichteter Erstarrung, d.h. gezieltem Kristallwachstum, gewinnen wegen ihrer verbesserten Eigenschaften zunehmend an Bedeutung. Die reproduzierbare Herstellung in großtechnischem Maßstab ist jedoch schwierig. Auf dem Gebiet der Photovoltaik, d.h. bei der Herstellung von Ausgangsmaterial (Wafern) für Solarzellen, hängt deren elektrischer Wirkungsgrad entscheidend von der Größe der Kristalle ab, die parallel zueinander verlaufen und einen möglichst großen Querschnitt haben sollten.

Dieser parallele Verlauf der Kristalle (Dendriten) setzt jedoch voraus, daß eine möglichst ebene Phasengrenze fest/flüssig allmählich von unten nach oben durch den Ingot wandert, die Verunreinigungen vor sich her schiebt und unter sich einen Einkristall oder großkristallinen Polykristall aufbaut. Eine ebene Phasengrenze fordert jedoch ein möglichst großes Verhältnis von vertikalen zu horizontalen Temperaturgradienten.

Beim Zonenschmelzen nach Czochralski wird ein polykristalliner Ingot aus Silizium senkrecht aufgehängt, und eine den Ingot umgebend Heizspule wird achsparallel von unten nach oben bewegt, so daß die Phasengrenze fest/flüssig der relativen Spulenbewegung folgt. Der Ingotquerschnitt ist jedoch begrenzt, und das Verfahren läuft nur langsam ab, so daß eine Steigerung der Produktionsmenge eine Vielzahl derartiger Vorrichtungen erforderlich macht.

Durch die EP 0 021 385 A1 ist es auch bekannt, Siliziumstäbe im Stranggußverfahren dadurch herzustellen, daß man den Ingot mittels einer angetriebenen Kühlplatte kontinuierlich aus einer unten offenen, beheizten Stranggußkokille abzieht und von oben aus einem Schmelzbehälter mit einem Bodenauslauf geregelt flüssiges Silizium nachchargiert. Die Bauhöhe ist jedoch beträchtlich, und der Ingot muß zur Vermeidung einer Reaktion mit dem Kokillenwerkstoff von einer Schutzschmelze umgeben sein, die mit Silizium nicht mischbar ist und beispielhaft aus Erdalkalifluoriden besteht.

Bei diesem Verfahren ändert sich jedoch laufend das Verhältnis von vertikalem zu horizontalem Temperaturgradienten, weil der Einfluß der Bodenkühlung mit wachsender Blocklänge abnimmt und der Wärmeverlust durch radiale Strahlung von der freigegebenen Blockoberfläche immer mehr zunimmt. Selbst eine anfänglich ebene Phasengrenze wird dadurch allmählich zu einer paraboloidförmigen Phasengrenze, und da das Kristallwachstum stets senkrecht zur Phasengrenze verläuft, haben die Kristalle schließlich eine radial konvergierende Richtung und nehmen an Größe ab.

Außerdem ist die Regelung eines solchen Verfahrens aufwendig und die Produktivität gleichfalls gering. Schließlich leidet das Verfahren unter der Gefahr einer Störung des Kristallisationsprozesses durch Erschütterungen des Bewegungsmechanismus.

Zur Erhöhung der Produktivität ist es durch die US 3 601 179 A weiterhin bekannt, eine fahrbare Schmelzkammer mit einem Kipptiegel zwischen zwei Reihen von Kristallisationskammern mit Standkokillen zu verfahren, die von Heizspulen umgeben sind und auf Kühlplatten stehen. Zum Abgießen der Siliziumschmelze wird die Schmelzkammer mit jeweils einer der Kristallisationskammern durch ein Schleusensystem von Vakuumschiebern verbunden, um den Abguß und die Kristallisation unter Vakuum oder einem Schutzgas durchführen zu können. Um die Standkokille entnehmen zu können, muß zunächst die Heizspule mittels eines Hydraulikantriebs um mehr als das Höhenmaß der Kokille angehoben werden, was zunächst einmal mindestens die doppelte Bauhöhe der Kristallisationskammern erforderlich macht, außerdem besitzt jede Kristallisationskammer eine eigene seitliche Tür für die Entnahme der Standkokille. Die Anlage ist dadurch sehr aufwendig und bei den häufigen Inspektionen und eventuellen Reparaturen an der Schmelzkammer nicht betriebsbereit.

Durch die DE 33 23 896 C2 ist es ferner bekannt, einen Tiegel bzw. eine Kokille mit ihrer Boden-Kühleinrichtung ortsfest in einer gemeinsamen Wärmedämmung unterzubringen, die im Bereich der Kokille außen von einer Induktionsspule umgeben ist. Mit dieser wird auch das Aufschmelzen der zunächst festen Charge bewirkt. Zur Erzeugung einer ebenen Phasengrenze wird das Verhältnis von Wandheizung zu Bodenkühlung der Kokille laufend verändert. Bei einem der Ausführungsbeispiele stehen mehrere Kokillen auf einer Grafitplatte, die mit Kühlkanälen versehen ist und unter der eine Widerstandsheizeinrichtung angeordnet ist. Deren Heizleistung muß also bei abgeschalteter Kühlung durch die Grafitplatte auf die Kokillen übertragen werden. Da Grafit ein relativ schlechter Wärmeleiter ist, kann dies nur mit erheblicher Zeitverzögerung und mit einem erheblichen Temperaturgradienten erfolgen. Zum gerichteten Erstarren wird die Heizung abgeschaltet und die Kühlung der Grafitplatte eingeschaltet. Auch dieser Vorgang ist mit erheblicher Zeitverzögerung und mit einem erheblichen Temperaturgradienten verbunden. Auch hierbei ist die Produktivität gering.

Die EP 218 088 B1 offenbart gleichfalls den Einfluß einer zeitlichen Veränderung des Wärmehaushalts auf die gerichtete, bzw. kolumnare Erstarrung von Schmelzen, die zuvor in eine Kokille eingegossen wurden Dies geschieht durch eine spezielle Ausbildung der Kokillenheizung, die auf dem Umfang geteilt ausgebildet sein kann, wobei für rechteckige Kokillen eine vierteilige und für runde Kokillen eine halbschalige Ausführung der Kokillenheizeinrichtung empfohlen wird. über die Ausbildung der übrigen Teile der Vorrichtung schweigt sich die Schrift jedoch aus.

Durch die US 2 970 075 ist es bekannt, weichmagnetische Werkstoffe aus Siliziumeisen mit mindesten 92 % Eisen und maximal 5 % Silizium dadurch gerichtet erstarren zu lassen, daß man auf den Boden einer Kokille ein Paket aus Streifen aus gewalztem Siliziumeisen mit einer Vorzugsrichtung der Kristallorientierung als Keimkörper legt und den Rest des Kokillenhohlraums mit einer extern erzeugten Schmelze auffüllt. Zur Vorheizung der Seitenwände der Kokille auf etwa 1400 °C vor dem Abguß ist angegeben, daß man im Kokillenhohlraum eine elektrische Widerstandsheizung oder eine andere Heizquelle vorsieht, die natürlich vor dem Abguß nach oben entfernt werden muß. Zur Durchführung einer gerichteten Erstarrung durch einen vertikalen Temperaturgradienten werden zwei Möglichkeiten angegeben, nämlich erstens ein stationärer Kühlkasten unter dem Kokillenboden und zweitens eine Düsenbatterie, mit der Kühlwasser gegen den Kokillenboden gesprüht werden kann. Ein schnelles Umschalten von Heizung auf Kühlung ist damit nicht möglich.

Durch die US 3 204 301 sind drei Verfahren und Vorrichtungen bekannt, Stahl dadurch gerichtet erstarren zu lassen, daß man eine extern erzeugte Stahlschmelze auf eine stationäre Bodenplatte aufgießt, die aus Kupfer besteht und mit Kühlwasseranschlüssen versehen ist. Die Schmelze läßt man anschließend durch einen vertikalen Temperaturgradienten gerichtet erstarren. In einem ersten Fall wird eine radiale Wärmezufuhr durch eine exotherme Reaktion eines Thermitgemischs aus Eisenoxid, Aluminium und einem Bindemittel erzeugt, das den Stahlblock konzentrisch umgibt. In den beiden übrigen Fällen ruht auf dem Rand der gekühlten Bodenplatte ein Hohlzylinder aus einem wärmedämmenden Feuerfestwerkstoff. In dem zweiten Fall wird die Heizenergie durch ringförmige Gasbrenner erzeugt, die den Hohlzylinder konzentrisch umgeben und zwischen sich alternierend ringförmige Kühlkörper für Luftstrahlen einschließen. Durch sequentielle Umschaltung kann ein zusätzlicher Temperaturgradient erzeugt werden, der jedoch starke radiale Komponenten hat. In dem dritten Fall ist der Hohlzylinder konzentrisch von mehrerer Induktionspulen umgeben, die als Kühlwasserrohre ausgebildet sind. Durch Abschalten des Spulenstromes kann von Heizen auf Kühlen umgeschaltet werden. Ein schnelles Umschalten ist damit jedoch auch nicht möglich.

Durch die GB 1 414 087 ist es bekannt, Einkristalle aus pulverförmigen Ausgangsstoffen dadurch zu erzeugen, daß man eine langgestreckte Kokille in einer etwa halbzylindrischen Heizkörperanordnung aus einzelnen elektrischen Heizkörpern mit mäanderförmigen Heizwiderständen unterbringt, die einzeln zu- und abschaltbar sind. Durch sequentielle Steuerung dieser Heizkörper läßt sich nach Art des Zonenschmelzens eine Phasengrenze fest/flüssig in horizontaler Richtung durch den Kokilleninhalt bewegen, die zu dem gewünschten Einkristall, beispielsweise aus Halbleitermaterial, führt. Kühleinrichtungen für eine Zwangskühlung sind nicht vorgesehen.

Eine Autorengruppe des ACCESS e.V. in Aachen und der BAYER AG in Krefeld-ürdingen berichtete anläßlich der ersten WCPEC vom 5. bis 9. Dezember 1994 unter dem Titel "A VIRTUAL CRYSTALLIZATION FURNACE FOR SOLAR SILICON" über das Prinzip der gerichteten Erstarrung und ein Rechenmodell für die Auslegung einer Kristallisationsanlage. über die Ausbildung der Vorrichtung schweigt sich das Vortragsmanuskript jedoch aus.

Durch die DE 198 55 061 A1 ist es bekannt, das Einschmelzen und Erstarrenlassen von Silizium in einem Tiegel durchzuführen, unter dessen Boden eine Bodenheizung angeordnet ist, die zur Erhöhung des Wärmeverlustes des Tiegels nach dem Einschmelzen wegbewegbar ist. Die Wirkung ist jedoch begrenzt. Alternativ kann eine bewegliche Kühlplatte vorgesehen sein, die zwischen die Bodenheizung und den Tiegelboden einschiebbar und aus dieser Position zurückziehbar ist. Beide Maßnahmen setzen jedoch bewegliche Anschlüsse voraus, nämlich für die Bodenheizung flexible Stromkabel und für die Kühlplatte flexible Wasserleitungen. Der konstruktive Aufwand ist beträchtlich, da die besagten Leitungen nicht an Einbauteilen scheuern dürfen. Außerdem verursachen bewegte Massen stets Erschütterungen, die für eine gerichtete Erstarrung kontraproduktiv sind.

Durch die DE 198 31 388 A1 ist es auch bekannt, unter dem Kokillenboden zunächst eine wärmeleitende Tragplatte, danach eine Struktur von Heizkörpern mit Zwischenräumen und darunter wiederum eine Wärmedämmplatte anzuordnen. Sowohl in der Tragplatte als auch in der Wärmedämmplatte und ggf. im Kokillenboden ist eine Vielzahl senkrechter jeweils fluchtender Ausnehmungen angeordnet, durch die platten- oder stiftförmige Kühlkörper einer heb- und senkbaren, wassergekühlten Kühlplatte bis in unmittelbare Nähe des Kokillenbodens angehoben werden können, um eine möglichst waagrechte Phasengrenze und ein senkrechtes Wachstum der Stengelkristalle zu erzeugen. Die Heizeinrichtung ist dabei so ausgebildet und angeordnet, daß die Kühlfinger auch durch die Heizkörper hindurch in die darüber liegenden Ausnehmungen angehoben werden können. Dies setzt einen erheblichen Bauaufwand und eine große Präzision in der Fertigung und Montage voraus. Die übertragung von Strahlungs- und/oder Kontaktwärme kann nur auf die Stirnseiten der Kühlkörper und auf deren obere Enden bzw. Längenanteile erfolgen, soweit diese in die Ausnehmungen eintauchen. Die Flächensumme aller Kühlkörper relativ zur Querschnittsfläche der Kokille ist gering, was einerseits die Wärmeverluste an die Kühlkörper während der Heiz- und Schmelzphase zwar gering hält, aber auch nicht ausschließt, andererseits während der Kühl- und Kristallisationsphase aber auch die Kühlleistung reduziert. Mit der Kühlplatte müssen auch die beweglichen Kühlwasseranschlüsse angehoben und abgesenkt werden. Durch den notwendigen Hub von Kühlplatte und Kühlkörpern - insbesondere bedingt durch die Höhe der Kühlkörper - werden ein erheblicher Freiraum unter der Wärmedämmplatte und damit eine beträchtliche Bauhöhe und ein zusätzliches Volumen der Kristallisationskammer bzw. der gesamten Vorrichtung erforderlich. Es ist zwar angegeben, daß die Wärmeübertragung durch Erhöhung des Gasdrucks verbessert werden kann, dies steht aber wiederum einem Betrieb der Vorrichtung unter Vakuum entgegen.

Demgegenüber liegt der Erfindung die Aufgabe zugrunde, ein Verfahren und eine Vorrichtung der eingangs beschriebenen Gattung zu schaffen, die einfach und kompakt im Aufbau ist und eine erschütterungsfreie und reproduzierbare Produktion von gerichtet erstarrten Blöcken mit großen Querschnitten der Blöcke selbst und der Kristalle in industriellem Maßstab und mit kurzen Zeiten für die Chargierung und Dechargierung erlaubt. Insbesondere sollen dabei auch das Aufschmelzen der Charge in der Kokille selbst und die anschließende Erstarrung beschleunigt werden, und es soll die Wanderung einer möglichst weitgehend ebenen Phasengrenze ermöglicht werden.

Die Lösung der gestellten Aufgabe erfolgt bei dem eingangs angegebenen Verfahren erfindungsgemäß dadurch, daß die Kühleinrichtung mit einem freien Abstand unterhalb der Bodenheizeinrichtung angeordnet wird und daß während der Schmelzperiode bei eingeschalteter Bodenheizeinrichtung zwischen dieser und der Kühleinrichtung ein Isolierschieber in waagrechter Richtung eingebracht wird, durch den eine Sichtverbindung zwischen der Bodenheizeinrichtung und der Kühleinrichtung unterbrochen wird, und daß während mindestens eines Teils der Erstarrungsphase der Isolierschieber in waagrechter Richtung herausgezogen wird.

Durch diese Maßnahme wird die gestellte Aufgabe in vollem Umfange gelöst. Insbesondere werden ein Verfahren und eine Vorrichtung der eingangs beschriebenen Gattung geschaffen, die mittels eines einfachen und kompakten Aufbaus eine erschütterungsfreie und reproduzierbare Produktion von gerichtet erstarrten Blöcken mit großen Querschnitten der Blöcke selbst und der Kristalle in industriellem Maßstab und mit kurzen Zeiten für die Chargierung und Dechargierung erlauben. Insbeondere erfolgt dabei auch das beschleunigte Aufschmelzen der Charge in der Kokille selbst, und in der anschließenden Erstarrungsphase wird die Wanderung einer weitgehend ebenen Phasengrenze ermöglicht.

Es ist dabei im Zuge weiterer Ausgestaltungen des Verfahrens besonders vorteilhaft, wenn - entweder einzeln oder in Kombination - :
* die Bodenheizeinrichtung während mindestens eines Teils der Erstarrungsphase abgeschaltet wird,
* nach dem Aufschmelzen einer Erstcharge mindestens eine Folgecharge nachchargiert wird, um das Volumen der Kokille zumindest weitgehend aufzufüllen, und/oder wenn
* die mindestens eine Folgecharge durch Abwärme der Kokille vorgeheizt wird.

Die Erfindung betrifft auch eine Vorrichtung mit einer Kristallisationskammer zum Einschmelzen von Metallen und Halbmetallen in einer Kokille und zum gerichteten Erstarren der Schmelze in dieser Kokille, die einen Boden besitzt, unter dem zur Zufuhr der Schmelzwärme eine mit Zwischenräumen versehene Bodenheizeinrichtung und zur Abfuhr der Erstarrungswärme bei der gerichteten Erstarrung eine Kühleinrichtung angeordnet sind.

Zur Lösung der gleichen Aufgabe ist eine solche Vorrichtung erfindungsgemäß dadurch gekennzeichnet, daß die Kühleinrichtung mit einem solchen Abstand unterhalb der Bodenheizeinrichtung angeordnet ist, daß zwischen dieser und der Kühleinrichtung verschiebbar ein Isolierschieber waagrecht verschiebbar angeordnet ist, durch den eine Sichtverbindung zwischen der Bodenheizeinrichtung und der Kühleinrichtung wahlweise unterbrechbar ist.

Es ist dabei im Zuge weiterer Ausgestaltungen der Vorrichtung besonders vorteilhaft, wenn - entweder einzeln oder in Kombination - :
* die Bodenheizeinrichtung zu mindestens 50 %, insbesondere zu mindestens 80 %, ihrer Flächenausdehnung in Richtung auf die Kühleinrichtung strahlungsdurchlässig ist,
* die Kühleinrichtung ortsfest angeordnet ist,
* als Bodenheizeinrichtung ein waagrechtes Gitter von Heizstäben vorgesehen ist, durch deren spaltförmige Zwischenräume die Wärmestrahlung bei herausgezogenem Isolierschieber in Richtung auf die Kühleinrichtung hindurchtreten kann,
* der Isolierschieber eine Platte aus Grafitfolien ist,
* die Oberfläche des Isolierschiebers in Richtung auf den Boden der Kokille Wärme reflektierende Eigenschaften aufweist,
* der Isolierschieber in einer waagrechten Linearführung gelagert ist,
* der Isolierschieber in einen Schieberkasten zurückziehbar ist, der seitlich an der Kristallisationskammer angeordnet ist,
* die Heizstäbe beidendig in Isolierleisten gelagert sind, die zur Abstützung der Kokille dienen,
* die Kokille seitlich und oben von einer Wärmedämmeinrichtung umgeben ist, die eine Zarge und einen abnehmbaren Deckel mit einer Zarge besitzt, in der eine Deckenheizeinrichtung gelagert ist,
* die Deckenheizeinrichtung aus einem Gitter aus Heizstäben besteht,
* die Kühleinrichtung aus einer mit Kühlkanälen versehenen Kühlplatte besteht,
* die Kühlplatte von einem Bodenrahmen aus Isolierstoff umgeben ist,
* die Heizstäbe des Gitters einen Durchmesser zwischen 10 und 50 mm aufweisen,
* die Heizstäbe des Gitters in einem lichten Abstand zwischen 10 und 50 mm angeordnet sind,
* in der Kristallisationskammer eine Chargiereinrichtung angeordnet ist,
* die Chargiereinrichtung oberhalb des Deckels angeordnet ist, und/ oder, wenn
* die Chargiereinrichtung durch Abwärme des Deckels beheizbar ist.

Ein Ausführungsbeispiel der Erfindung wird nachfolgend anhand der Figuren 1 bis 5 näher erläutert.

Es zeigen:
- Figur 1: einen Vertikalschnitt durch eine geschlossene Kristallisationskammer im Betriebszustand,
- Figur 2: die wesentlichen Teile des Gegenstandes nach Figur 1 in einer schematisierten perspektivischen Explosionsdarstellung.
- Figur 3: eine schematisierte Draufsicht auf die Bodenheizeinrichtung,
- Figur 4: die Wärmestrahlungsverhältnisse während der Schmelzphase bei eingeschobenem Isolierschieber in einem Vertikalschnitt in schematischer Darstellung und
- Figur 5: die Wärmestrahlungsverhältnisse während der Erstarrungsphase bei herausgezogenem Isolierschieber in schematischer Darstellung analog Figur 4.

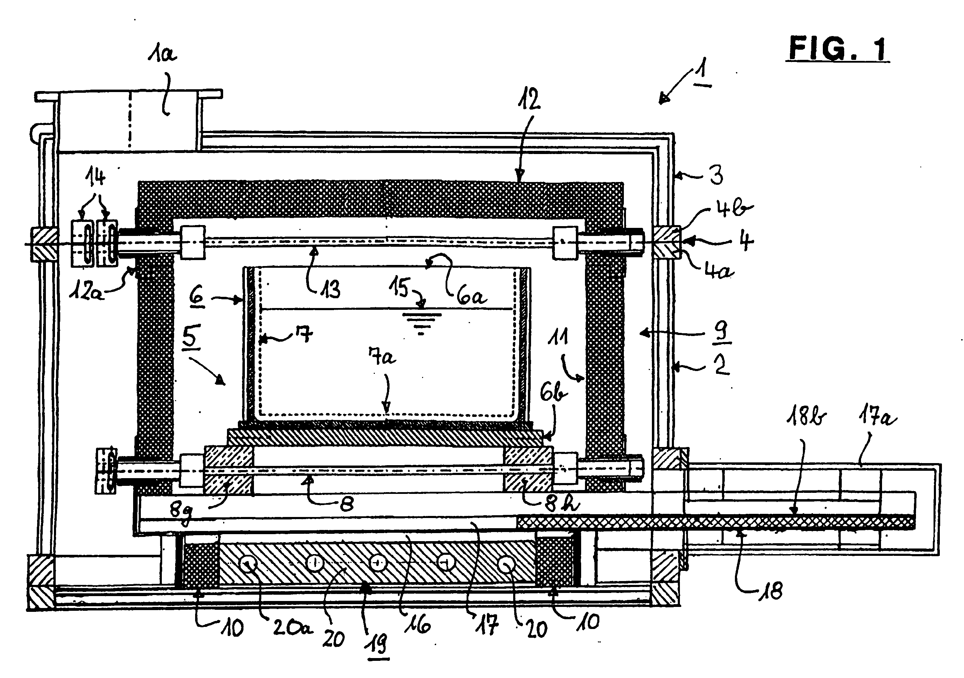

In Figur 1 ist eine gasdichte, doppelwandige und kühlbare Kristallisationskammer 1 dargestellt, die mittels eines Saugstutzens 1a an einen nicht dargestellten Vakuumpumpsatz angeschlossen ist. Die Kristallisationskammer 1 hat die Form eines hohlen Quaders und besteht aus einem Kammerunterteil 2 und einem Kammeroberteil 3, die an einer waagrechten Trennfuge 4 mit Dichtflanschen 4a und 4b aneinanderstoßen. Die Trennfuge 4 muß nicht genau waagrecht liegen; sie muß es beim öffnen der Kristallisationskammer 1 nur ermöglichen, daß die Kristallisationseinrichtung 5 aus mindestens einer Richtung zugänglich und aus der Kristallisationskammer 1 entnehmbar ist.

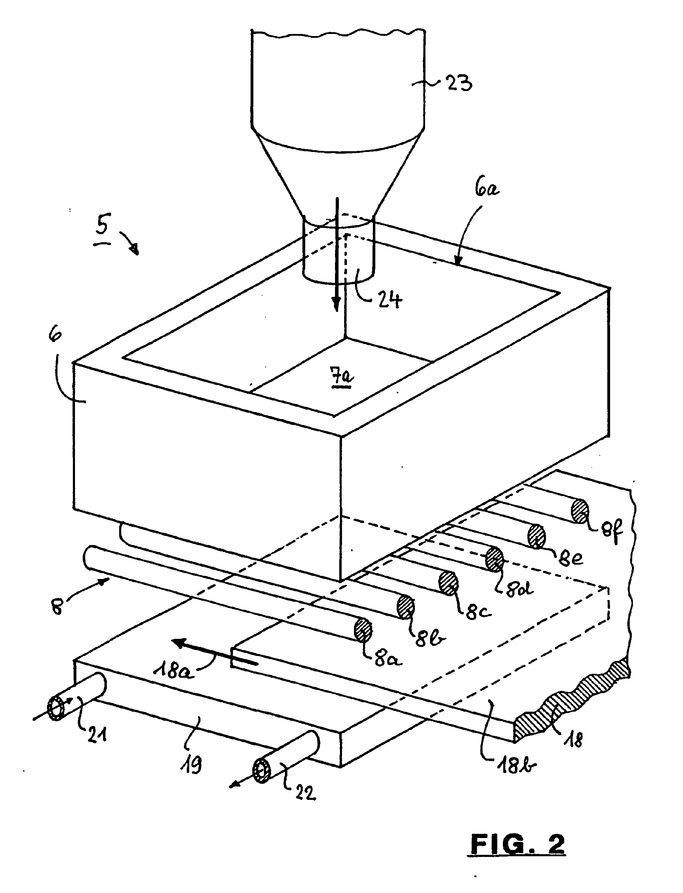

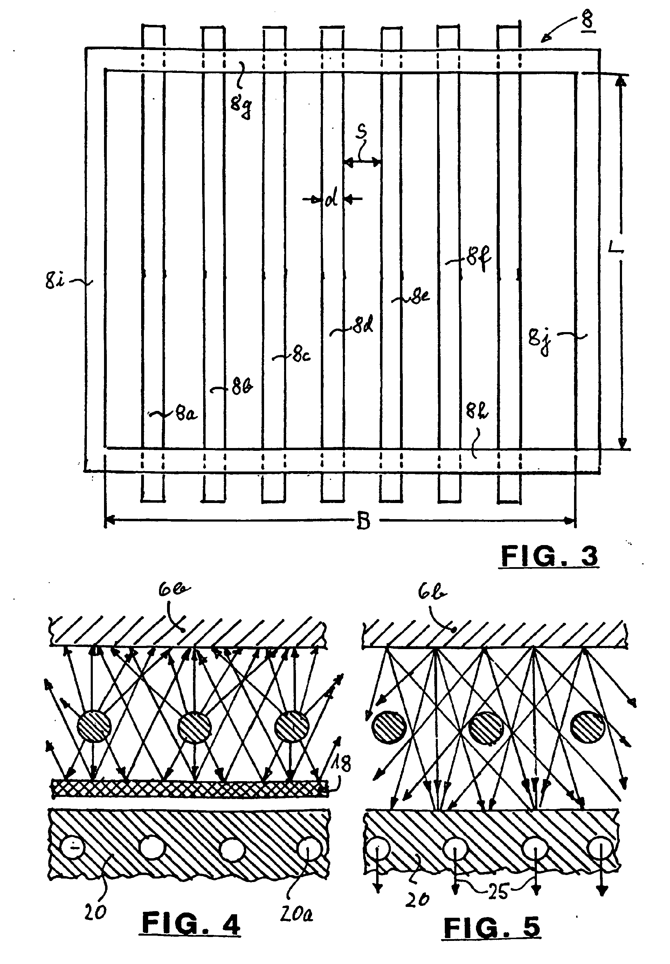

In der Kristallisationskammer 1 befindet sich eine Kristallisationseinrichtung 5, zu der eine quaderförmige Kokille 6 gehört, die eine obenliegende Kokillenöffnung 6a, innere Wände und einen Boden aus Siliziumdioxid (Quarz) sowie einen Behälter 7 aus Grafit mit einem Boden 7a besitzt. Die Kokille 6 ruht auf einer gut wärmeleitenden Stützplatte 6b. Unter dem Boden 7a bzw. der Stützplatte 6b ist eine Bodenheizeinrichtung 8 angeordnet, die aus einzelnen Heizstäben 8a bis 8f etc. besteht, die an beiden Enden in Isolierleisten 8g und 8h gelagert sind, die sich durch Seitenteile 8i und 8j zu einem Rahmen ergänzen. Die Heizstäbe bestehen aus Grafit und haben Durchmesser "d" zwischen 5 und 10 mm und lichte Abstände "s" zwischen 10 und 50 mm voneinander. Dadurch wird ein durchsichtiges Gitter gebildet, was aus den Figuren 2 und 3 deutlicher erkennbar ist. Auf den Isolierleisten 8g und 8h und ggf. auf den Seitenteilen 8i und 8j ruht auch die Stützplatte 6b mit der Kokille 6.

Die Anordnung aus Kokille 6 und Bodenheizeinrichtung 8 ist oben und an den Seiten von einer strahlungsdichten Wärmedämmeinrichtung 9 umgeben, die aus einem Bodenrahmen 10, einer Zarge 11 und einem abnehmbaren Deckel 12 besteht, in dessen Zarge 12a eine gleichfalls gitterförmige Deckenheizeinrichtung 13 aus einer Reihe von analogen Heizstäben angeordnet ist, deren Kontakte 14 zum Abnehmen des Deckels 12 trennbar sind.

Durch die Heizeinrichtungen 8 und 13 läßt sich aus einchargiertem festem Siliziumgranulat eine Siliziumschmelze 15 erzeugen, in der nach dem Aufschmelzen eine zumindest nahezu isotherme Temperaturverteilung vorliegt. Unterhalb der Bodenheizeinrichtung 8 befindet sich ein flacher, quaderförmigen Hohlraum 16, in den von der Seite her mittels einer waagrechten Linearführung 17 ein Isolierschieber 18 in Richtung des Pfeils 18a (Figur 2) mittels eines nicht dargestellten Antriebs einschiebbar ist. Die Linearführung 17 setzt sich zur rechten Seite hin in einen Schieberkasten 17a fort, der vakuumdicht an die Kristallisationskammer 1 angeflanscht ist.

Unterhalb der Kokille 6 und der Linearführung 17 ist als unterer Abschluß des Hohlraums 16 ortsfest eine rechteckige und in etwa dem waagrechten Umriß der Kokille 6 entsprechende als flache Kühlplatte 20 ausgebildete metallene Kühleinrichtung 19 mit Kühlkanälen 20a angeordnet, die über Anschlüsse 21 und 22 mit einem Kühlmedium versorgt werden können (Figur 2).

Durch das Einschieben des Isolierschiebers 18, der eine wärmereflektierende Oberfläche 18b besitzt, wird erreicht, daß die Wirkung der Kühleinrichtung 19 aufgehoben wird und die Wärmestrahlung der eingeschalteten Bodenheizeinrichtung 8, verstärkt durch die Wärmereflexion des Isolierschiebers 18, auf die Stützplatte 6b und den Kokillenboden 7a einwirkt und den zunächst festen Kokilleninhalt aufschmilzt. Die Sichtverbindung zur Kühleinrichtung 19 ist während dieser Zeit aufgehoben.

Durch die Abschaltung der Bodenheizeinrichtung 8 und das Herausziehen des Isolierschiebers 18 in die in Figur 1 gezeigte Stellung wird die Sichtverbindung der Stützplatte 6b mit der Kühleinrichtung 19 hergestellt und die bis dahin isotherme Temperaturverteilung in der Schmelze 15 so verändert, daß in der Schmelze 15 eine nahezu waagrechte Phasengrenze von unten nach oben wandert, die eine gerichtete Erstarrung der Schmelze zu einem Siliziumblock ermöglicht.

Aus Figur 2 geht ergänzend folgendes hervor: Oberhalb der Mitte der Kokillenöffnung 6a ist ein Chargierbehälter 23 angeordnet, in dem eine weitere Charge aus granulatförmigem Silizium angeordnet ist. An der Unterseite des Chargierbehälters befindet sich eine Chargieröffnung 24 mit einem nicht gezeigten, steuerbaren Verschluß. Damit hat es folgende Bewandnis: Wenn der Chargierbehälter innerhalb der Kristallisationskammer 1 angeordnet ist - was in Figur 1 nicht dargestellt ist - gibt der Deckel 12 gibt nach oben hin erhebliche Energiemengen durch Strahlung ab, die den Chargierbehälter 23 mit seinem Inhalt aufheizen. In diesem Bereich können Temperaturen von etwa 400 °C herrschen. Dadurch wird das Granulat sehr wirksam entgast und insbesondere von Wasser und/oder Wasserdampf befreit.

Das Volumen des in der Kokille 6 zunächst befindlichen Siliziumgranulats, das erhebliche Hohlräume enthält, ist durch den Aufschmelzprozeß auf etwa die Hälfte bis zwei Drittel geschrumpft, so daß die Kokille 6 nur teilweise gefüllt ist, was zu einer entsprechend geringeren Produktivität der Anlage führt. Durch Freigabe der Chargieröffnung 24 und Nachchargieren der vorgewärmten, getrockneten und/oder entgasten und sehr rieselfähigen Charge wird das verfügbare Restvolumen der Kokille 6 aufgefüllt, wodurch die Produktivität entsprechend erhöht und bis nahezu verdoppelt wird. Außerdem wird das ansonsten erfolgende Spritzen der Schmelze durch Gasfreisetzung aus der neuen Charge in der Schmelze verhindert. Erst danach wird die Bodenheizeinrichtung 8 abgeschaltet, der Isolierschieber 18 herausgezogen (Figur 1) und der Kristallisationsprozeß eingeleitet, der alsdann ungestört wie oben beschrieben abläuft.

Wie aus Figur 3 hervorgeht, sind die Maße "d" und "s" in gewissen Grenzen optimierbar, um die beschriebene Strahlungsdurchlässigkeit und Sichtverbindung herzustellen. Die Verhältnisse von "d" und "s" bestimmen eben diese Strahlungsdurchlässigkeit, d.h. die Heizstäbe 8a bis 8f etc. sollen einerseits relativ dicht zueinander angeordnet sein, um eine gleichmäßige Beheizung des Kokillenbodens bzw. der Stützplatte 6b zu erreichen, andererseits sollten die lichten Abstände "s" bzw. der durch deren Flächensumme gebildete freie Querschnitt relativ groß sein, um die Strahlungsdurchlässigkeit bzw. die "Sichtverbindung" möglichst wenig zu behindern. Außerdem müssen die Heizstäbe aus Festigkeitsgründen und wegen der zu erzeugenden elektrischen Heizleistung einen ausreichenden Durchmesser besitzen. Diese Forderungen stehen einander teilweise entgegen, weshalb es einiger Überlegungen zur Optimierung der Verhältnisse bedarf. Die Innenmaße "L" (Länge) und "B" (Breite) des aus den Isolierleisten 8g und 8h und den Seitenteilen 8i und 8j gebildeten Rahmens können beispielsweise jeweils 700 mm oder mehr betragen, wobei diese Maße sich nach der Grundfläche bzw. der Größe der Kokille 6 richten.

Figur 4 zeigt die von den Heizstäben 8a bis 8f etc. (schraffierte Kreise) ausgehenden Wärmestrahlungsverhältnisse während der Schmelzphase bei eingeschobenem Isolierschieber 18. Die direkte Beheizung der Stützplatte 6b und deren indirekte Beheizung durch Reflexion von der Oberfläche des Isolierschiebers 18 sind durch Pfeile angedeutet.

Figur 5 zeigt die Wärmestrahlungsverhältnisse während der Erstarrungsphase bei herausgezogenem Isolierschieber. In diesem Falle ist der Wärmestrom umgekehrt, d.h. die von der Stützplatte 6b der Kokille 6 ausgehende Wärmestrahlung (gleichfalls durch Pfeile angedeutet) trifft, durch die Heizstäbe 8a bis 8f etc. (schraffierte Kreise) nahezu unbehindert auf die Kühlplatte auf, wird in dieser an das Kühlwasser abgegeben und durch dieses abgeführt, was durch die Pfeile 25 angedeutet ist.

Wie aus den vorgehenden Ausführungen hervorgeht, sind vor allem wichtig die Nähe zur und der ständige "Sichtkontakt" der Bodenheizeinrichtung 8 mit der Stützplatte 6b der Kokille 6 sowie die metallene und vorzugsweise ortsfeste Kühleinrichtung 19 und deren unterbrechbarer "Sichtkontakt" mit der Stützplatte 6b der Kokille 6. Das einzige bewegliche Teil zum praktisch trägheitslosen Umschalten von Schmelzen auf Erstarren ist der Isolierschieber 18 in Verbindung mit einem Aus- oder Einschalten der praktisch trägheitslosen Bodenheizung 8.

Nach dem Herausziehen des Isolierschiebers 18 wird die Sichtverbindung der Stützplatte 6b mit der Kühleinrichtung 19 hergestellt, und die Wärmestrahlung der Stützplatte 6b kann unter fortgesetztem Wärmeentzug aus dem Inhalt der Kokille 6 nahezu unbehindert durch die Heizstäbe 8a, 8b, 8c, 8d, 8e und 8f an die Kühleinrichtung 19 abgegeben werden, die sie wiederum an das Kühlwasser überträgt. Die Wärmeübertragung durch Strahlung ist äußerst effektiv, da sie mit dem 4. Exponenten der Temperaturdifferenzen abläuft. Seitliche Temperaturgradienten, die zu einer gewölbten Phasengrenze und zu einem schrägen Dendritenwachstum führen könnten, treten praktisch nicht auf. Die Kühleinrichtung mit ihren Kühlmittelanschlüssen braucht zum Umschalten nicht bewegt zu werden.

Das Umschalten von Heizung auf Kühlung muß indessen nicht schlagartig erfolgen: Die Aussagen, daß der Isolierschieber 18 während mindestens eines Teils der Erstarrungsphase entfernt wird und daß die Bodenheizeinrichtung während mindestens eines Teils der Erstarrungsphase abgeschaltet wird, läßt durchaus die Möglichkeit zu, zu Beginn der Erstarrungsphase ein langsames "Ankeimen" durchzuführen, um die Ausbildung eines für Solarsilizium unerwünschten feinkristallinen Gefüges zu vermeiden. Gerade diese Möglichkeit wird durch die Erfindung besonders gefördert.

### Bezugszeichenliste:

- 1: Kristallisationskammer
- 2: Kammerunterteil
- 3: Kammeroberteil
- 4: Trennfuge
- 4a: Dichtflansch
- 4b: Dichtflansch
- 5: Kristallisationseinrichtung
- 6: Kokille
- 6a: Kokillenöffnung
- 6b: Stützplatte
- 7: Behälter
- 7a: Boden
- 8: Bodenheizeinrichtung
- 8a: Heizstab
- 8b: Heizstab
- 8c: Heizstab
- 8d: Heizstab
- 8e: Heizstab
- 8f: Heizstab
- 8g: Isolierleiste
- 8h: Isolierleiste
- 8i: Seitenteil
- 8j: Seitenteil
- 9: Wärmedämmeinrichtung
- 10: Bodenrahmen
- 11: Zarge
- 12: Deckel
- 12a: Zarge
- 13: Deckenheizeinrichtung
- 14: Kontakte
- 15: Siliziumschmelze
- 16: Hohlraum
- 17: Linearführung
- 17a: Schieberkasten
- 18: Isolierschieber
- 18a: Pfeil
- 18b: Oberfläche
- 19: Kühleinrichtung
- 20: Kühlplatte
- 20a: Kühlkanäle
- 21: Anschluß
- 22: Anschluß
- 23: Chargierbehälter
- 24: Chargieröffnung
- 25: Pfeile

- B: Breite
- d: Durchmesser
- L: Länge
- s: lichte Abstände

## Patentansprüche

1. Verfahren zum Einschmelzen von Metallen und Halbmetallen in einer Kokille (6) und zum gerichteten Erstarren der Schmelze (15) in dieser Kokille (6), die einen Boden (7a) besitzt, unter dem zur Zufuhr der Schmelzwärme eine Bodenheizeinrichtung (8) und zur Abfuhr der Erstarrungswärme bei der gerichteten Erstarrung eine Kühleinrichtung (19) angeordnet sind, wobei als Bodenheizeinrichtung (8) unter dem Boden (7a) der Kokille (6) eine mit Zwischenräumen versehene Widerstandsheizeinrichtung verwendet wird, **dadurch gekennzeichnet, daß** die Kühleinrichtung (19) mit einem freien Abstand unterhalb der Bodenheizeinrichtung (8) angeordnet wird, und daß während der Schmelzperiode bei eingeschalteter Bodenheizeinrichtung (8) zwischen dieser und der Kühleinrichtung (19) ein Isolierschieber (18) in waagrechter Richtung eingebracht wird, durch den eine Sichtverbindung zwischen der Bodenheizeinrichtung (8) und der Kühleinrichtung (19) unterbrochen wird, und daß während mindestens eines Teils der Erstarrungsphase der Isolierschieber (18) in waagrechter Richtung herausgezogen wird.

2. Verfahren nach Anspruch 1, **dadurch gekennzeichnet, daß** die Bodenheizeinrichtung (8) während mindestens eines Teils der Erstarrungsphase abgeschaltet wird.

3. Verfahren nach Anspruch 1, **dadurch gekennzeichnet, daß** nach dem Aufschmelzen einer Erstcharge mindestens eine Folgecharge nachchargiert wird, um das Volumen der Kokille (6) zumindest weitgehend aufzufüllen.

4. Verfahren nach Anspruch 1, **dadurch gekennzeichnet, daß** die mindestens eine Folgecharge durch Abwärme der Kokille (6) vorgeheizt wird.

5. Vorrichtung mit einer Kristallisationskammer (1) zum Einschmelzen von Metallen und Halbmetallen in einer Kokille (6) und zum gerichteten Erstarren der Schmelze (15) in dieser Kokille (6), die einen Boden (7a) besitzt, unter dem zur Zufuhr der Schmelzwärme eine mit Zwischenräumen versehene Bodenheizeinrichtung (8) und zur Abfuhr der Erstarrungswärme bei der gerichteten Erstarrung eine Kühleinrichtung (19) angeordnet sind, **dadurch gekennzeichnet, daß** die Kühleinrichtung (19) mit einem solchen Abstand unterhalb der Bodenheizeinrichtung (8) angeordnet ist, daß zwischen dieser und der Kühleinrichtung (19) ein Isolierschieber (18) waagrecht verschiebbar angeordnet ist, durch den eine Sichtverbindung zwischen der Bodenheizeinrichtung (8) und der Kühleinrichtung (19) wahlweise unterbrechbar ist.

6. Vorrichtung nach Anspruch 5, **dadurch gekennzeichnet, daß** die Bodenheizeinrichtung (8) zu mindestens 50 % ihrer Flächenausdehnung in Richtung auf die Kühleinrichtung (19) strahlungsdurchlässig ist.

7. Vorrichtung nach Anspruch 6, **dadurch gekennzeichnet, daß** die Bodenheizeinrichtung (8) zu mindestens 80 % ihrer Flächenausdehnung in Richtung auf die Kühleinrichtung (19) strahlungsdurchlässig ist.

8. Vorrichtung nach Anspruch 5, **dadurch gekennzeichnet, daß** die Kühleinrichtung (19) ortsfest angeordnet ist.

9. Vorrichtung nach Anspruch 5, **dadurch gekennzeichnet, daß** als Bodenheizeinrichtung (8) ein waagrechtes Gitter von Heizstäben (8a, 8b, 8c, 8d, 8e, 8f) vorgesehen ist, durch deren spaltförmige Zwischenräume die Wärmestrahlung bei herausgezogenem Isolierschieber (18) in Richtung auf die Kühleinrichtung (19) hindurchtreten kann.

10. Vorrichtung nach Anspruch 5, **dadurch gekennzeichnet, daß** der Isolierschieber (18) eine Platte aus Grafitfolien ist.

11. Vorrichtung nach Anspruch 5, **dadurch gekennzeichnet, daß** die Oberfläche (18b) des Isolierschiebers (18) in Richtung auf den Boden (7a) der Kokille (6) Wärme reflektierende Eigenschaften aufweist.

12. Vorrichtung nach Anspruch 5, **dadurch gekennzeichnet, daß** der Isolierschieber (18) in einer waagrechten Linearführung (17) gelagert ist.

13. Vorrichtung nach Anspruch 5, **dadurch gekennzeichnet, daß** der Isolierschieber (18) in einen Schieberkasten (17a) zurückziehbar ist, der seitlich an der Kristallisationskammer (1) angeordnet ist.

14. Vorrichtung nach Anspruch 8, **dadurch gekennzeichnet, daß** die Heizstäbe (8a, 8b, 8c, 8d, 8e, 8f) beidendig in Isolierleisten (8g, 8h) gelagert sind, die zur Abstützung der Kokille (6) dienen.

15. Vorrichtung nach Anspruch 5, **dadurch gekennzeichnet, daß** die Kokille (6) seitlich und oben von einer Wärmedämmeinrichtung (9) umgeben ist, die eine Zarge (11) und einen abnehmbaren Deckel (12) mit einer Zarge (12a) besitzt, in der eine Deckenheizeinrichtung (13) gelagert ist.

16. Vorrichtung nach Anspruch 15, **dadurch gekennzeichnet, daß** die Deckenheizeinrichtung (13) aus einem Gitter aus Heizstäben besteht.

17. Vorrichtung nach Anspruch 5, **dadurch gekennzeichnet, daß** die Kühleinrichtung (19) aus einer mit Kühlkanälen (20a) versehenen Kühlplatte (20) besteht.

18. Vorrichtung nach Anspruch 16, **dadurch gekennzeichnet, daß** die Kühlplatte (20) von einem Bodenrahmen (10) aus Isolierstoff umgeben ist.

19. Vorrichtung nach Anspruch 9, **dadurch gekennzeichnet, daß** die Heizstäbe (8a bis 8f) des Gitters einen Durchmesser "d" zwischen 10 und 50 mm aufweisen.

20. Vorrichtung nach Anspruch 9, **dadurch gekennzeichnet, daß** die Heizstäbe (8a bis 8f) des Gitters in einem Abstand "s" zwischen 10 und 50 mm angeordnet sind.

21. Vorrichtung nach Anspruch 5, **dadurch gekennzeichnet, daß** in der Kristallisationskammer (1) eine Chargiereinrichtung (23) angeordnet ist.

22. Vorrichtung nach Anspruch 21, **dadurch gekennzeichnet, daß** die Chargiereinrichtung (23) oberhalb des Deckels (12) angeordnet ist und daß die Chargiereinrichtung (23) durch Abwärme des Deckels (12) beheizbar ist.

## Claims

1. A method for melting metals and semimetals in a mould (6) and for controlled solidifying of the molten mass (15) in the mould (6), with a base (7a), below which are located a base heating device (8) for introducing the melting heat and a cooling device (19) for removing the solidifying heat during controlled solidifying, wherein a resistance heating device provided with clearances is used as the base heating device (8) below the base (7a) of the mould (6), **characterized in that** the cooling device (19) is located at a distance below the base heating device (8), and that an insulating slide (18), by which a line of sight between the base heating device (8) and the cooling device (19) is interrupted, is introduced horizontally between the heating device and the cooling device (19) when the base heating device (8) is switched on during the melting period, and that the insulating slide (18) is withdrawn horizontally during at least part of the solidifying phase.

2. The method according to claim 1, **characterized in that** the base heating device (8) is switched off during at least part of the solidifying phase.

3. The method according to claim 1, **characterized in that** at least one subsequent batch is loaded after a first batch has been melted in order to at least substantially replenish the volume of the mould (6).

4. The method according to claim 1, **characterized in that** the at least one subsequent batch is preheated by the waste heat from the mould (6).

5. A device including a crystallization chamber (1) for melting metals and semimetals in a mould (6) and for controlled solidifying of the melt (15) in this mould (6), which has a base (7a), below which are located a base heating device (8) furnished with clearances for introducing the melting heat, and a cooling device (19) for removing the solidifying heat during controlled solidifying, **characterized in that** the cooling device (19) is located at such a distance below the base heating device (8) that an insulating slide (18), by which a line of sight between the base heating device (8) and the cooling device (19) can be interrupted optionally, can be introduced horizontally between the heating device and the cooling device (19).

6. The device according to claim 5, **characterized in that** at least 50% of the surface area of the base heating device (8) facing the cooling device (19) is radiation-permeable.

7. The device according to claim 6, **characterized in that** at least 80% of the surface area of the base heating device (8) facing the cooling device (19) is radiation-permeable.

8. The device according to claim 5, **characterized in that** the cooling device (19) is arranged in a fixed manner.

9. The device according to claim 5, **characterized in that** a horizontal lattice of heating rods (8a, 8b, 8c, 8d, 8e, 8f) is provided as the base heating device (8), and radiated heat can pass towards the cooling device (19) through the slit-like clearances therebetween when the insulating slide (18) is withdrawn.

10. The device according to claim 5, **characterized in that** the insulating slide (18) is a plate of graphite films.

11. The device according to claim 5, **characterized in that** the surface (18b) of the insulating slide (18) facing towards the base (7a) of the mould (6) has heat reflecting properties.

12. The device according to claim 5, **characterized in that** the insulating slide (18) is supported in a horizontal linear guide (17).

13. The device according to claim 5, **characterized in that** the insulating slide (18) is retractable into a slide box (17a) that is arranged on the side of the crystallization chamber (1).

14. The device according to claim 8, **characterized in that** the heating rods (8a, 8b, 8c, 8d, 8e, 8f) are supported at both ends in insulating strips (8g, 8h) which serve to brace the mould (6).

15. The device according to claim 5, **characterized in that** the mould (6) is surrounded on the sides and at the top by a thermal insulation means (9) that has a frame (11) and a removable cover (12) with a frame (12a) in which a cover heating device (13) is supported.

16. The device according to claim 15, **characterized in that** the cover heating device (13) consists of a lattice arrangement of heating rods.

17. The device according to claim 5, **characterized in that** the cooling device (19) consists of a cooling plate (20) furnished with cooling ducts (20a).

18. The device according to claim 16, **characterized in that** the cooling plate (20) is surrounded by a base frame (10) made from insulating material.

19. The device according to claim 9, **characterized in that** the heating rods (8a to 8f) of the lattice arrangement have a diameter "d" between 10 and 50 mm.

20. The device according to claim 9, **characterized in that** the heating rods (8a to 8f) of the lattice arrangement are arranged with a separation "s" between 10 and 50 mm.

21. The device according to claim 5, **characterized in that** a loading device (23) is located inside the crystallization chamber (1).

22. The device according to claim 21, **characterized in that** the loading device (23) is located above the cover (12) and **in that** the loading device (23) is heatable with the waste heat from the cover (12).

## Revendications

1. Procédé pour la fusion de métaux et semi-métaux dans un creuset (6) et pour la solidification dirigée de la coulée (15) dans ce creuset (6) comportant un fond (7a) sous lequel sont disposés un dispositif de chauffage de fond (8) pour apporter la chaleur de fusion et un dispositif de refroidissement (19) pour évacuer la chaleur de solidification lors de la solidification dirigée, sachant qu'on utilise comme dispositif de chauffage de fond (8), sous le fond (7a) du creuset (6), un dispositif de chauffage à résistance pourvu d'intervalles, **caractérisé en ce que** le dispositif de refroidissement (19) est disposé en dessous du dispositif de chauffage de fond (8) à une distance libre et que, pendant la période de fusion, le dispositif de chauffage de fond (8) étant activé, on intègre entre celui-ci et le dispositif de refroidissement (19), dans le sens horizontal, un curseur d'isolation (18) qui coupe une liaison visuelle entre le dispositif de chauffage de fond (8) et le dispositif de refroidissement (19) et que le curseur d'isolation (18) est extrait dans le sens horizontal pendant au moins une partie de la phase de solidification.

2. Procédé selon la revendication 1, **caractérisé en ce que** le dispositif de chauffage de fond (8) est désactivé pendant au moins une partie de la phase de solidification.

3. Procédé selon la revendication 1, **caractérisé en ce que**, après la fusion d'une première charge, au moins une charge suivante est rechargée afin de remplir au moins dans une large mesure le volume du creuset (6).

4. Procédé selon la revendication 1, **caractérisé en ce que** l'au moins une charge suivante est préchauffée par la chaleur dégagée par le creuset (6).

5. Dispositif comportant une chambre de cristallisation (1) pour la fusion de métaux et semi-métaux dans un creuset (6) et pour la solidification dirigée de la coulée (15) dans ce creuset (6), lequel creuset comporte un fond (7a) pourvu d'intervalles sous lequel est disposé un dispositif de chauffage de fond (8) pour apporter la chaleur de fusion et un dispositif de refroidissement (19) pour évacuer la chaleur de solidification lors de la solidification dirigée, **caractérisé en ce que** le dispositif de refroidissement (19) est disposé en dessous du dispositif de chauffage de fond (8) à une distance telle qu'est disposée entre celui-ci et le dispositif de refroidissement (19) un curseur d'isolation (18) mobile horizontalement qui permet de couper une liaison visuelle entre le dispositif de chauffage de fond (8) et le dispositif de refroidissement (19).

6. Dispositif selon la revendication 5, **caractérisé en ce que** le dispositif de chauffage de fond (8) laisse passer le rayonnement pour au moins 50 % de son extension de surface en direction du dispositif de refroidissement (19).

7. Dispositif selon la revendication 6, **caractérisé en ce que** le dispositif de chauffage de fond (8) laisse passer le rayonnement pour au moins 80 % de son extension de surface en direction du dispositif de refroidissement (19).

8. Dispositif selon la revendication 5, **caractérisé en ce que** le dispositif de refroidissement (19) est disposé à emplacement fixe.

9. Dispositif selon la revendication 5, **caractérisé en ce qu'**il est prévu comme dispositif de chauffage de fond (8) une grille horizontale de barres chauffantes (8a, 8b, 8c, 8d, 8e, 8f) à travers les intervalles en forme de colonnes de laquelle le rayonnement thermique peut passer en direction du dispositif de refroidissement (19) lorsque le curseur d'isolation (18) est tiré.

10. Dispositif selon la revendication 5, **caractérisé en ce que** le curseur d'isolation (18) est une plaque composée de films de graphite.

11. Dispositif selon la revendication 5, **caractérisé en ce que** la surface (18b) du curseur d'isolation (18) présente des propriétés de réfléchissement de chaleur en direction du fond (7a) du creuset (6).

12. Dispositif selon la revendication 5, **caractérisé en ce que** le curseur d'isolation (18) s'appuie dans un guide linéaire horizontal (17).

13. Dispositif selon la revendication 5, **caractérisé en ce que** le curseur d'isolation (18) peut être retiré dans un caisson de curseur (17a) qui est disposé latéralement sur la chambre de cristallisation (1).

14. Dispositif selon la revendication 8, **caractérisé en ce que** les barres chauffantes (8a, 8b, 8c, 8d, 8e, 8f) s'appuient par leurs deux extrémités dans des baguettes d'isolation (8g, 8h) qui servent à soutenir le creuset (6).

15. Dispositif selon la revendication 5, **caractérisé en ce que** le creuset (6) est entouré latéralement et en haut par un dispositif isolant thermique (9) qui possède un châssis (11) et un couvercle amovible (12) pourvu d'un châssis (12a) dans lequel s'appuie un dispositif de chauffage de couvercle (13).

16. Dispositif selon la revendication 15, **caractérisé en ce que** le dispositif de chauffage de couvercle (13) consiste en une grille faite de barres chauffantes.

17. Dispositif selon la revendication 5, **caractérisé en ce que** le dispositif de refroidissement (19) consiste en une plaque de refroidissement (20) pourvue de canaux de refroidissement (20a).

18. Dispositif selon la revendication 5, **caractérisé en ce que** la plaque de refroidissement (20) est entourée d'un cadre de fond (10) en matériau isolant.

19. Dispositif selon la revendication 9, **caractérisé en ce que** les barres chauffantes (8a à 8f) de la grille présentent un diamètre "d" compris entre 10 et 50 mm.

20. Dispositif selon la revendication 9, **caractérisé en ce que** les barres chauffantes (8a à 8f) de la grille sont disposées à une distance "s" comprise entre 10 et 50 mm.

21. Dispositif selon la revendication 5, **caractérisé en ce que**, dans la chambre de cristallisation (1), un dispositif de chargement (23) est disposé.

22. Dispositif selon la revendication 21, **caractérisé en ce que** le dispositif de chargement (23) est disposé au dessus du couvercle (12) et **en ce que** le dispositif de chargement (23) peut être chauffé par la chaleur dégagée par le couvercle (12).
